Europäisches Patentamt

European Patent Office

Office européen des brevets

(11) Publication number: **0 413 614 A2**

# EUROPEAN PATENT APPLICATION

(21) Application number: 90309108.0

(51) Int. Cl.5: **H05K 3/36, H01R 9/09**

(22) Date of filing: 20.08.90

(30) Priority: 18.08.89 JP 213244/89

(43) Date of publication of application:
20.02.91 Bulletin 91/08

(84) Designated Contracting States:
DE FR GB

(71) Applicant: SEMICONDUCTOR ENERGY
LABORATORY CO., LTD.
398 Hase
Atsugi-shi Kanagawa-ken, 243(JP)

(72) Inventor: Mase, Akira
Terasu Hase 3-3, 381-1, Hase
Atsugi-shi, Kanagawa-ken 243(JP)

(74) Representative: Milhench, Howard Leslie et al
R.G.C. Jenkins & Co. 26 Caxton Street
London SW1H 0RJ(GB)

(54) **Electrical connections and a method for making the same.**

(57) A method of making electrical connections be-
tween electrode arrangements formed on first and
second substrates is described which is particularly
advantageous for making connections in liquid cry-
stal displays. The first substrate is placed over the
second substrate with the respective electrodes in
registry and with a UV-light-curable adhesive there-
between. The UV-light-curable adhesive carries first
and second kinds of particles dispersed therein. The
first and second substrates are pressed against each
other and exposed to UV light in order to harden the
adhesive. The first kind of particles are electrically
conductive particles and preferably are resiliently
deformable and function to establish current paths
between the electrodes of the first and second substrates, and the second kind of particles are smaller
than the first and function to prevent the first kind of
particles from being destroyed by excessive de-
formation.

# F I G. 5

EP 0 413 614 A2

# ELECTRICAL CONNECTIONS AND A METHOD FOR MAKING THE SAME

## BACKGROUND OF THE INVENTION

### FIELD OF THE INVENTION

The present invention relates to an improved electrical connection and a method for making the same.

### DESCRIPTION OF THE PRIOR ART

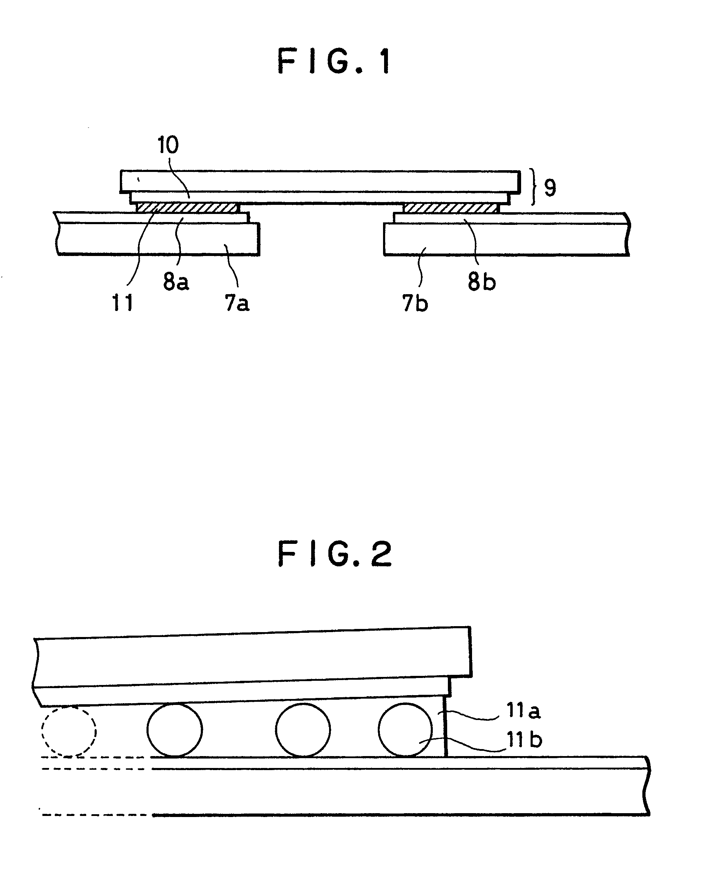

The electrical connections between substrates carrying electrode arrangements have commonly been made by means of FPC's (Flexible Printed Circuits) and such a connection is illustrated in Fig. 1 of the accompanying drawings. A substrate 7a is provided with an electrode arrangement 8a which consists of a number of electrode strips which are required to make electrical connection with corresponding electrode strips 8b provided on another substrate 7b. An FPC 9 comprises a flexible sheet made from polyimide and carrying a number of conductive strips 10 corresponding to the strips of the substrates 7a and 7b. The coupling together of the strips 10, 8a and 8b of the flexible sheet and the substrates is made through anisotropic conductive films 11.

This method of making electrical connection gives rise to the following shortcomings. First, since the connection is made through an FPC, there are two coupling sites which require much care and processing as compared with the case of a single site connection. The possibility of connection error is also doubled. Second, the FPC is adhered to the substrates at a high temperature and under pressure. The flexible sheet is thermally expanded during the thermal treatment, and consequently the alignment of the conductive strips 10 with the corresponding strips 8a and 8b cf the substrates is often sheared, resulting in disconnections or connection errors. Third, the FPC sometimes separates from the substrates when external force is applied just after the connection is completed.

These disadvantages are considered to originate from the structure of the anisotropic conductive film. Fig. 2 of the accompanying drawings is an explanatory view showing the structure of the conventional anisotropic conductive film and it will be seen that the film is comprised of a sheet 11a of adhesive in which a large number of conductive particles 11b are uniformly dispersed. Because the conductive particles are non-deformable, the electrodes 10 and 8a are easily disconnected from the particles as a consequence of thermal expansion or contraction with environmental temperature changes.

## OBJECTS AND SUMMARY OF THE INVENTION

It is thus an object of the present invention to provide an improved connection system which inter alia will increase the yield of electrical connections made between electrode strips formed on substrates.

In accordance with the present invention, electrodes on a first substrate are placed over and aligned with counterpart electrodes on a second substrate with a UV-light-curable electrically conductive adhesive between them and the first and second substrates are pressed against each other and exposed to UV light in order to harden the adhesive. The UV-light-curable adhesive has first and second kinds of particles dispersed therein, the first kind of particles being electrically conductive and preferably resilient and functioning to form current paths between the electrodes of the first and second substrates, and the second kind of particles functioning to protect the first kind of particles against excessive deformation.

In an exemplary embodiment of the present invention which is described in detail hereinafter, the first kind of particles comprise fine spheres or beads of synthetic resin material, such as polystyrene, which are coated with a film of conductive metal, for example gold. The second kind of particles are slightly smaller than the first kind of particles and may be made from any material which has sufficient hardness properties and is not easily crushed, for example $SiO_2$.

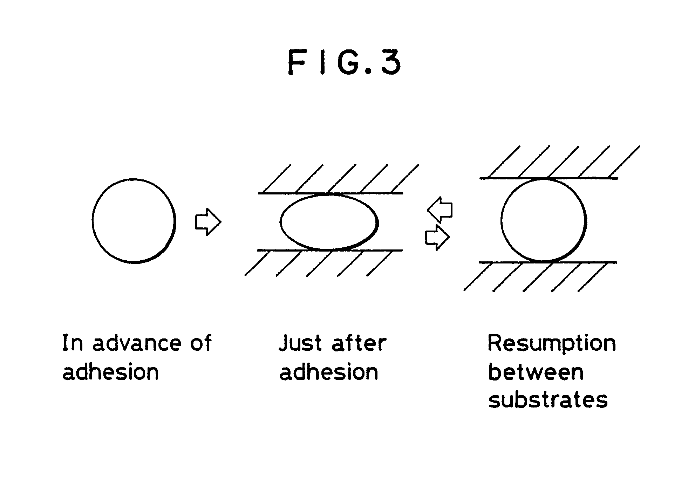

Fig. 3 of the accompanying drawings illustrates the action of the first kind of particles in the making of an electrical connection according to the teachings of the present invention. In this illustration the particles are formed so as to be resilient.

As illustrated in Fig. 3, the first kind of particles maintain their 100% diameter in advance of the application of pressure. The diameter is decreased to 60-95% of the original value when the pair of substrates are joined under pressure. The electrical contact between the first kind of particles and the electrodes of the substrates, however, is ensured at least for as long as any relative deformation of the substrates does not exceed 100%-(60-95%) of the diameter because of the resilience of the particles. This is made certain furthermore by making use of light instead of heat to harden the adhesive carrying the first and second particles. Other shortcomings arising from the high temperature arising during heat treatment are also removed.

The foregoing and further features of the present invention are set forth with particularity in the appended claims and will be well understood by those possessed of the relevant skills from consideration of the following detailed description of exemplary embodiments of the invention given with reference to the accompanying drawings.

## BRIEF DESCRIPTION OF THE DRAWINGS

Fig. 1 is a side view showing a prior art FPC connection;

Fig. 2 is an expanded partial view of the prior art connection of Fig. 1,

Fig. 3 is an explanatory view showing the action of conductive particles in the making of an electrical connection in accordance with the teachings of the present invention;

Figs. 4 and 5 are perspective and expanded partial cross-sectional views showing electrical connections in accordance with an embodiment of the present invention;

Fig. 6 shows the destruction of particles of the first kind under excessive pressure; and

Fig. 7 is an expanded cross-sectional view showing an electrical connection in accordance with another embodiment of the present invention.

## DETAILED DESCRIPTION OF THE EMBODIMENTS

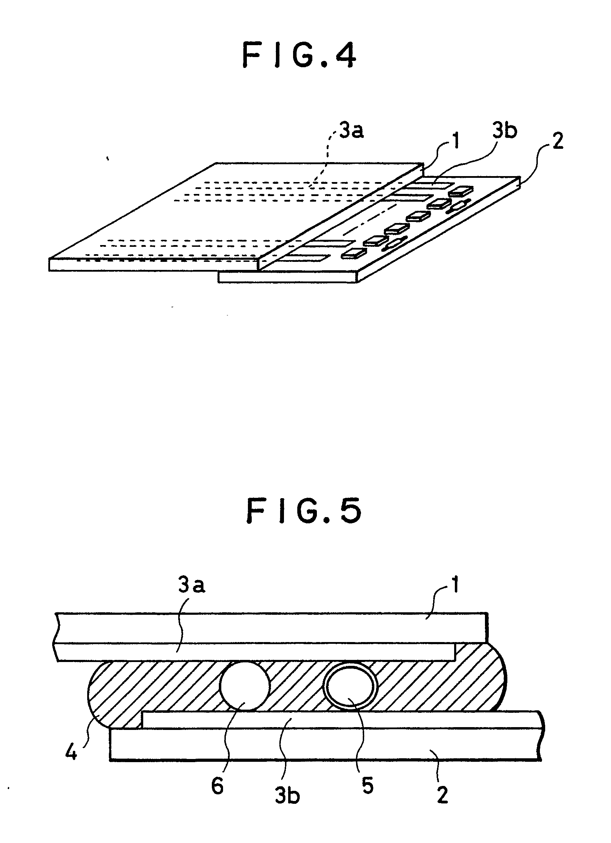

Referring now to Figs. 4 and 5, which illustrate a preferred embodiment of the invention, a glass substrate 1 is formed with a number of parallel conductive strips 3a made from a transparent conductive material such as indium tin oxide (ITO), and a printed circuit board 2 is provided with a number of parallel conductive strips 3b made of copper corresponding to the strips 3a of the glass substrate 1. The glass substrate 1 is used for example for forming a liquid crystal display by sandwiching a liquid crystal layer between it and a similar counterpart substrate. The circuit formed on the board 2 is provided to supply drive signals to the strips 3a and 3b.

Fig. 5 shows the connection between the strips 3a and 3b. Between the board 2 and the substrate 1 is a UV-light-curable electrically insulating adhesive 4 in which a number of fine particles 5 of a first kind and fine particles 6 of a second kind are dispersed. The diameter of the first kind of particles 5 is slightly larger than that of the second kind of particles 6. The adhesive 4 is exposed to UV light with the board 2 being pressed against the substrate 1, and the first kind of particles are deformed under this pressure until the distance between the board and the substrate decreases to the diameter of the second kind of particles. The second kind of particles thus protect the first kind of particles from being too much deformed.

Since the first kind of particles have to make electrically conductive paths between the strips 3a and 3b, they are made from a conductive material such as a metal. Preferred resilient particles can be provided as the first kind of particles by coating a metallic film such as Au film on fine spheres of organic resin such as polystyrene. The second kind of particles can be made from any material as long as they are sufficiently hard and are not easily crushed by the pressure that is applied during the curing process.

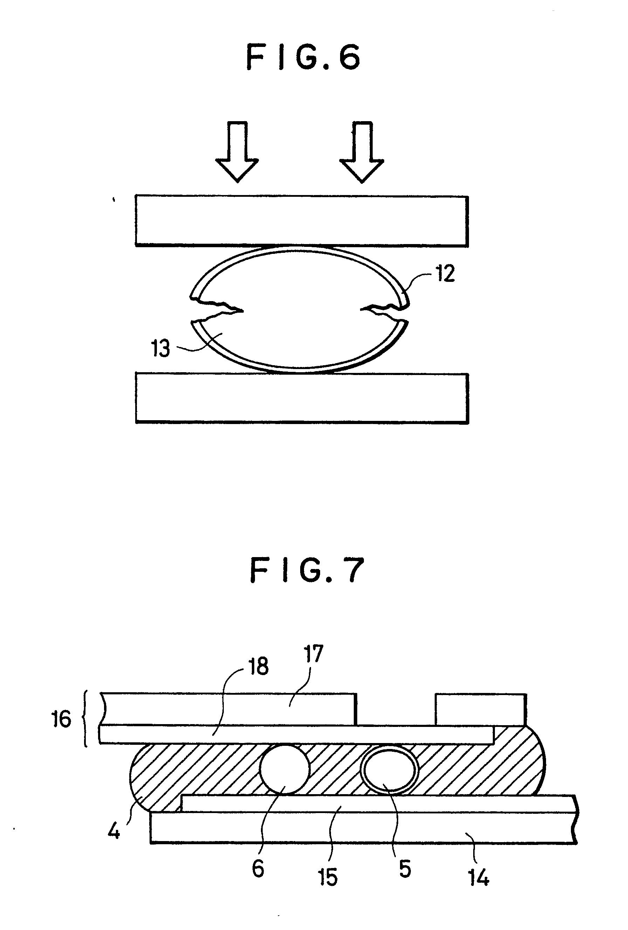

For comparative reference, when electrical connections were made between electrodes on a glass substrate and a printed board as illustrated in Fig. 5 but without the use of the second kind of particles, many of the polystyrene particles 13 coated with Au films 12 which were used as the first kind of particles were crushed by the pressure applied during the curing process, as is illustrated in Fig. 6, so that disconnections happened. It is not necessarily impossible to adjust the pressure in order not to break the first kind of particles even without provision of the second kind of particles, but such adjustment is very difficult and is not practical. The second kind of particles are thus indispensable. The polystyrene particles coated with Au films can be deformed without destruction to 60% of their diameter, which fact was confirmed by experiment. The diameter of the second kind of particles, therefore, is chosen to be from 60% to 95% of that of the first kind of particles.

In the following, detailed explanations will be provided of the fabrication of several electrical connections in accordance with the teachings of the present invention and of tests that were conducted on the resulting connections.

## EXAMPLE 1:

A 1200 angstroms thick ITO film was coated on a first 1.1 mm thick soda lime glass substrate by sputtering. The sheet resistance of the ITO film was measured to be 25Ω. The ITO film was then patterned into 640 parallel strips of 175 μm width and 30 mm length by a known photolighographic process. The distance between adjacent strips was 350 μm. (The interval was 175 μm). The strips were designed to be extensions of electrodes defining pixels for a liquid crystal display.

A 1000 angstroms thick ITO film was coated on a second 1.1 mm thick soda lime glass substrate by EB evaporation. The ITO film was then severed into 640 parallel strips of 175 $\mu$m width and 30 mm length by a known photolithographic process. The distance between adjacent strips was 350 um corresponding to those of the first substrate. The strips were designed to be connected to driving circuits for the liquid crystal display including ICs. A 5500 angstroms thick Ni film was formed on the ITO strips by plating. The 500 angstroms thickness of the Ni film was then replaced by a 500 angstroms thick Au film also by plating.

The first substrate was placed over the second substrate with a UV-light-curable resin in which first and second kinds of particles were dispersed, the resin having been coated on the first or second substrate in advance by a dispenser. Care was taken to align the strips of the first substrate exactly with the corresponding strips of the second substrate. The first kind of particles were prepared by coating polystyrene particles of 7.5 $\mu$m diameter film 1000 angstroms thick Au films. The second kind of particles were $SiO_2$ particles of 5.0 $\mu$m diameter. The ratio by weight of resin to the first and second kinds of particles was chosen to be 107:14:4. The first and second substrates were then pressed against each other under 2.4 Kg/cm² and exposed to UV light in order to harden the resin.

As a result, the two sets of electrode strips were electrically coupled. The connection resistance per strip was 0.5 $\Omega$. The insulation resistance between adjacent strips was 2.8 x $10^9 \Omega$. When thermal shock was repeatedly applied 100 times by varying the temperature between -30°C and +70°C for an hour, no connection was found to have been destroyed throughout 120 connection sites.

**EXAMPLE 2 :**

This example will be explained in conjunction with Fig. 7. A 1200 angstroms thick ITO film was coated on a first 1.1 mm thick soda lime glass substrate 14 by sputtering. The sheet resistance of the ITO film was measured to be 25$\Omega$. The ITO film was then patterned into a number of parallel strips of 175 $\mu$m width and 30 mm length by a known photolithographic process. The number of the strips was 640. The distance between adjacent strips was 350 $\mu$m. (The interval was 175 $\mu$m). the strips were designed to be extensions of electrodes defining pixels for a liquid crystal display.

OLBs (Outer Lead Bonding) of 8 TABs (Tape Automated Bonding) were used as second substrates 17. 80 parallel electrode strips 18 of 175 $\mu$m width and 30 mm length were formed in each OLB. These electrodes were of copper film of 0.035 mm thickness. The other end of each TAB terminated in an ILB (Inner Lead Bonding). The substrates 17 of the TAB were made from a Kapton film of 0.125 mm thickness manufactured by Dupont.

The second substrates 16 were placed over the first substrate 14 with a UV-light-curable resin 4 in which first and second kinds of particles were dispersed therebetween. In so doing, care was taken to align the strips of the first substrate exactly with the corresponding strips of the second substrates. The first kind of particles were prepared by coating polystyrene particles of 7.5 $\mu$m diameter with 1000 angstroms thick Au films. The second particles were $SiO_2$ spheres of 5.0 $\mu$m diameter. The ratio by weight of the resin to the first and second kinds of particles was chosen to be 107:14:4. The first and second substrates were then pressed against each other under 2.4 Kg/cm² and exposed to UV light in order to harden the resin in the same manner as in the first example.

As a result, the two sets of electrode strips were electrically coupled. The connection resistance per strip was 0.5$\Omega$ . The insulation resistance between adjacent strips was 2.8 x $10^9 \Omega$. When thermal shock was repeatedly applied 100 times by varying the temperature between -30°C and +70°C for an hour, no connection was found to have been destroyed throughout 120 connection sites.

**EXAMPLE 3 :**

This example was conducted in substantially the same manner as for Example 1 except that the second substrate was different. Two printed circuit boards were used as the second substrates. Each board was made of a 1.1 mm thick glass epoxy substrate on which 320 parallel electrodes of 175 m width and 30 mm length were formed and connected with circuits formed on the same board. The electrodes were of copper film of 0.125 mm thickness. The other processes were the same as those of Example 1 and will not be repeated.

As a result, these two sets of electrode strips were electrically coupled. The connection resistance per strip was 0.5$\Omega$. The insulation resistance between adjacent strips was 2.8 x $10^9 \Omega$. When thermal shock was repeatedly applied 100 times by varying the temperature between -30°C and +70°C for an hour, no connection was found destroyed throughout 120 connection sites.

The foregoing description of preferred embodiments has been presented for purposes of illustration. It is not intended to be exhaustive or to limit the invention to the precise form described, and obviously many modifications and variations are possible without departure from the scope of the invention. For example, although the embodiments were designed to be suitable for manufacture of liquid crystal devices, the present invention can be applied to other devices such as image sensors for example.

**Claims**

1. A method of making an electrical connection between a first electrode and a second electrode, said method comprising the use of an electrically insulating adhesive interposed between said first and second electrodes and said adhesive having incorporated therein a first kind of particles which are electrically conductive and a second kind of particles which are smaller than the first kind of particles, said first kind of particles being deformable under pressure between said first and second electrodes and said second kind of particles being such that the distance between said first and second electrode arrangements cannot be reduced below a distance substantially equal to the size of said second particles.

2. The method of claim 1 wherein said first kind of particles comprise electrically insulating resilient particles coated with an electrically conductive film.

3. The method of claim 2 wherein said electrically insulating particles comprise polystyrene and said conductive film comprises gold.

4. The method of any preceding claim wherein said second kind of particles comprise $SiO_2$.

5. The method of any preceding claim wherein said first and second electrodes each comprise a plurality of parallel conductive strips to be connected in registry with each other.

6. The method of any preceding claim wherein said first and/or said second electrode is formed upon a transparent substrate.

7. The method of claim 6 wherein the electrode that is formed upon a transparent substrate comprises a transparent electrically conductive film.

8. The method of any of claims 1 to 5 wherein said first and/or said second electrode is formed on a printed circuit board.

9. The method of any preceding claim wherein said adhesive is curable with UV light.

10. The method of any preceding claim wherein the diameter of said second kind of particles is 60% to 95% of the diameter of said first kind of particles.

11. The method of any preceding claim wherein said first kind of particles are resilient.

12. A method of making electrical connection between a first electrode arrangement formed on a first substrate and a second electrode arrangement formed on a second substrate, said method comprising placing said first substrate on said second substrate with the first electrode arrangement aligned with the second electrode arrangement and with a UV-light-curable adhesive therebetween said adhesive including a first kind of conductive particles and a second kind of particles whose diameter is smaller than that of said first kind of particles, and exposing said adhesive to UV light with said first and second substrates pressed together such that the distance between the opposed surfaces of said first and second electrode arrangements becomes substantially the same as the diameter of said second kind of particles with said first kind of particles being deformed.

13. The method of claim 12 wherein said first kind of particles comprise beads of resilient synthetic resin material coated with an electrical conductor.

14. An electrical device including one or more electrical connections made by the method of any preceding claim.

15. An adhesive for use in making electrical connections, said adhesive having first and second kinds of particles incorporated therein, said first kind of particles being electrically conductive and deformable under pressure and said second kind of particles being smaller than the first kind of particles and serving to protect the first kind of particles from excessive pressure application.

16. The adhesive of claim 15 wherein said first kind of particles comprise resilient synthetic resin beads coated with an electrical conductor.

17. The adhesive of claim 16 wherein said first kind f particles comprise polystyrene beads coated with a film of gold.

18. The adhesive of any of claims 15 to 17 wherein said second kind of particles comprise $SiO_2$.

19. The adhesive of any of claims 15 to 18 wherein the adhesive is adapted to be cured by UV light.

20. A liquid crystal display wherein electrical connection is made to drive electrodes of the display by a method as claimed in any of claims 1 to 13.

# F I G. 1

# F I G. 2

# FIG.3

In advance of
adhesion

Just after
adhesion

Resumption
between
substrates

# F I G.4

# F I G.5

# F I G. 6

12

13

# F I G. 7

18  17

16

4

6  15  5  14